# EUROPÄISCHE PATENTANMELDUNG

(11) **EP 1 376 691 A2**
(43) Veröffentlichungstag der Anmeldung: **02.01.2004**
(21) Anmeldenummer: 02016488.5
(22) Anmeldetag: 23.07.2002
(51) Int. Cl.: H01L 23/495, H01L 21/48

(54) **Verfahren zur Herstellung von Systemträgern aus metallischem Trägerband sowie Metallstreifen mit Trägerbereich für elektrische Bauelemente**

(30) Priorität: 21.06.2002 DE 10227936
(71) Anmelder: W. C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzei, Günter, 63791 Karlstein (DE)
(74) Vertreter: Kühn, Hans-Christian

(57) **Zusammenfassung**

Zur Herstellung von Systemträgern aus einem metallischen Trägerband (1)als langgestreckter Metallstreifen mit nachfolgender Kunststoffumspritzung als Chip-Modul, insbesondere als Modul für kontaktlose Chipkarten, wird das Trägerband (1) entlang einer durch Randstreifen bzw. Ränder (2, 3) vorgegebenen Transportrichtung (7) in einzelne Segmente als Träger-Bereich (5) für Module aufgeteilt und zwecks späterer Trennung vorgestanzt, wobei der als Träger vorgesehene Bereich so ausgestanzt wird, dass er entlang der Transportrichtung (7) gesehen von zwei sich diametral gegenüberliegenden zungenartigen Vorsprüngen (15, 16) des Trägerbändes umgeben ist; dabei wird das Trägerband (1) jeweils zwischen zungenartigem Vorsprung und einem Eingangsbereich (21) des Trägerbereichs (5) so gestanzt, dass eine zum Trägerbereich (5) gerichtete Spitze des zungenartigen Vorsprungs (15, 16) eine vordere Schnittkante sowie seitliche Schnittkanten erhält, die auf jeder Seite mit einer Verbindung als Steg im Trägerband (1) zwischen dem zungenartigen Teil des Vorsprungs (15, 16) und dem Trägerbereich (5) versehen sind, wobei die Stege jeweils eine Zone mit verringerten Profil-Querschnittsflächen (als Sollbruchlinie) aufweisen, die nach Umspritzung des auf dem Träger-Bereich (5) aufgebrachten Bauelements durch mechanische Einwirkung (Druck oder zusätzliches Stanzen) aufgetrennt wird. Der Transport wird mit Hilfe der Perforation (4) durchgeführt.

Die Trennung des Chip-Moduls vom Trägerband erfolgt in der Praxis in einem späteren Bearbeitungsschritt, wie z.B. bei der Herstellung von Chipkarten, in denen der Chip-Modul eingesetzt wird.

## Beschreibung

Die Erfindung betrifft ein Verfahren zur Herstellung von Systemträgern aus einem metallischen Trägerband als langgestreckter Metallstreifen für die Aufbringung von elektrischen oder elektronischen Bauelementen mit nachfolgender Kunststoffumspritzung als Chip-Modul, insbesondere als Modul für kontaktlose Chipkarten, wobei das Trägerband entlang einer durch Randstreifen vorgegebenen Transportrichtung in einzelne Segmente als Träger-Bereich für Module aufgeteilt und zwecks späterer Trennung vorgestanzt wird; weiterhin betrifft die Erfindung ein mit (Rand-) Perforation zur Führung entlang einer Transportrichtung versehenes Trägerband, das einen durch Stanzen gebildeten Träger-Bereich für die Aufbringung eines elektrischen oder elektronischen Bauelements mit anschließender Kunststoff-Umspritzung aufweist.

Aus der DE 197 32 915 C1 ist ein Verfahren zur Herstellung eines Chip-Moduls vorzugsweise für eine Chipkarte bekannt, bei dem ein elektronisches Bauelement als Chip auf einen Chipträgerfestigungsabschnitt eines gestanzten Chipträgers aus Metall angeordnet wird, wobei Anschlussdrähte des Chips zu Chipträgerkontaktabschnitten geführt werden, die zum Chipträgerbefestigungsabschnitt mittels Schlitze beabstandet angeordnet sind, worauf der Chip mit den Anschlussdrähtchen mittels einer Vergussmasse auf dem Chipträger eingekapselt wird.

Nach Stanzen des Chipträgers wird der Abstand zwischen dem Chipträgerbefestigungsabschnitt und den Chipträgerkontaktabschnitten durch einen im Schlitz nahen Bereich durchgeführten Prägevorgang auf ein durch das Durchfließen der Vergussmasse verhindemdes Maß verringert. Die Materialstärke des Chipträgers wird durch den Prägevorgang auf 30 bis 70% der ursprünglichen Materialstärke verringert. Die Schlitze werden durch den Prägevorgang auf einer Breite von 4 bis 7 um verengt. Auf diese Weise ist es möglich, ein Chipmodul auf besonders einfache und kostengünstige Weise herzustellen.

Weiterhin ist aus der DE 100 14 620 A1 ein Verfahren zur Herstellung eines Trägerbandes mit einer Vielzahl von vorgefertigten Halbleiter-Chips (für Chipkarten), die auf dem Trägerband platziert werden, bekannt. Hierzu wird eine metallisierte Kunststoff-Folie bzw. metallische Folie zum Ausbilden von wenigstens einem Kontaktelement bereitgestellt, dem Trägerband zugeführt und mit zumindest einer Anschlussfläche des Chips verbunden, um eine Leiterschleife oder Antenne für kontaktlose Chipkarten zu erhalten.

Es handelt sich dabei um ein verhältnismäßig aufwendiges Verfahren.

Aus der EP 0 454 440 B1 ist ein Verfahren zur Herstellung einer Halbleitereinrichtung bekannt, wobei ein Systemträger einen peripheren Bereich aufweist, der einen Bereich zur Aufnahme des Chips und eine Vielzahl von Leiterbahnfingerbereichen und Arretierungsfingerbereichen enthält. Nach Kontaktieren von Chipanschlüssen mit Leiterbahnfingerbereichen mittels Bonddraht wird der Chip in eine Formmulde eingebracht und anschließend werden Chip und Bonddrähte zu einem Kunststoffgehäuse vergossen, so dass die Leiterbahnfingerbereiche aus dem Gehäuse ragen. Anschließend wird ein jedes der Leiterbahnfingerbereiche vom peripheren Bereich des Rahmens abgetrennt.

Auch hierbei handelt es sich um ein verhältnismäßig aufwendiges Verfahren.

Weiterhin ist aus der DE 197 08 617 C2 bzw. der entsprechenden US 6 191 951 B1 ein Chipkartenmodul bekannt, welche einen Halbleiterchip umfasst, der elektrisch leitend mit einem metallischen Anschlussrahmen kontaktiert ist, in dem Kontaktflächen ausgebildet sind, wobei der Halbleiterchip mit Anschlussflächen voran auf den Anschlussrahmen aufgesetzt und über Anschlussdrähte mit Kontaktflächen elektrisch leitend kontaktiert ist; der Anschlussrahmen ist eben ausgebildet, wobei der Halbleiterchip wenigstens auf einer Seite mit einer elektrisch isolierenden Schutzschicht versehen ist, auf deren vom Halbleiterchip abgewandter Oberfläche die Anschlussflächen so ausgebildet sind und mit den Kontaktierungsstellen des Halbleiterchips elektrisch leitend verbunden sind. Vorzugsweise sind die Anschlussflächen an die Kontaktflächen gelötet, wobei die Lötverbindung aus Zinnbleilot besteht.

Als problematisch erweisen sich solche Anordnungen bei Chipmodulen als Massenprodukt, das von einem langgestreckten Metallband entnommen und vereinzelt werden soll, da es sich hierbei in der Regel um aufgewickelte Spulenware handelt, die an einen Chipkartenhersteller so geliefert wird, dass er nur noch die einzelnen Chipmodule zu entnehmen braucht.

Die Erfindung stellt sich die Aufgabe, die Herstellung von Systemträgern für elektrische oder elektronische Bauelemente aus einem metallischen Trägerband bzw. aus langgestreckten Metallstreifen anzugeben, wobei nach einer Kunststoffumspritzung die aus Systemträger und Bauelement bestehenden Chipmodule auf möglichst einfache Weise vereinzelt werden sollen. Dabei soll insbesondere der Schritt zur Vereinzelung bzw. die Vorbereitung eines solchen Vereinzelungsschrittes von Chipmodulen aus einem Trägerband vereinfacht werden und eine hohe Zuverlässigkeit erzielt werden.

Die Aufgabe wird verfahrensgemäß dadurch gelöst, dass der als Träger vorgesehene Bereich so ausgestanzt wird, dass er entlang der Transportrichtung gesehen von zwei sich diametral gegenüberliegenden zungenartigen Vorsprüngen des Trägerbandes umgeben ist, wobei das Trägerband jeweils zwischen zungenartigem Vorsprung und einem Eingang des Trägerbereichs wenigstens zum Teil so gestanzt wird, dass eine zum Trägerbereich gerichtete Spitze des zungenartigen Vorsprungs eine vordere Schnittkante sowie seitliche Schnittkanten erhält, die auf jeder Seite mit einer Verbindung als Steg im Metallstreifen zwischen dem zungenartigen Teil des Vorsprungs und dem Trägerbereich versehen sind, wobei die Stege jeweils eine Zone mit verringerter Profil-Querschnittsfläche aufweisen, die nach Umspritzung des auf dem Träger-Bereich aufgebrachten Bauelements durch mechanische Einwirkung aufgetrennt wird. Diese Auftrennung in einzelne Chipmodule (Entfernung der Chip-Module aus dem Trägerband) erfolgt in der Regel jedoch erst bei der späteren Weiterverarbeitung, wie es beispielsweise bei der Herstellung von Chipkarten erforderlich ist. Die Abtrennung erfolgt durch Druck oder zusätzliches Stanzen im Bereich der Zone verringerter Profil-Querschnittsfläche der jeweiligen Stege. Vorteilhafte Ausgestaltungen des Verfahrens sind in den Ansprüchen 2 bis 18 angegeben.

Als besonders vorteilhaft erweist es sich, dass bei einem langgestreckten Trägerband mit einer Vielzahl von Chipmodulen durch Vorstanzen nur noch eine geringe mechanische Belastung am Gehäuse des jeweiligen Chipmoduls beim Vereinzeln auftritt.

In einer vorteilhaften Ausgestaltung des Verfahrens bleiben die zungenartigen Vorsprünge beim Stanzen über jeweils zwei Stege mit dem Träger-Bereich verbunden, wobei die Stege im Bereich ihrer jeweiligen Zone mit gegenüber dem Profil des übrigen Trägerbandes reduzierte Querschnittsfläche eine Sollbruchlinie erhalten; dabei ist die Zone bzw. die Sollbruchlinie als Einkerbung im Steg ausgebildet; die Zone verringerten Profil-Querschnitts bzw. die Sollbruchlinie wird vorteilhafterweise als Einkerbung durch ein Folgeschnitt-Prägewerkzeug eingeprägt.

Ein wesentlicher Vorteil ist darin zu sehen, dass aufgrund der Einkerbung der Stege der Chipmodul formatgerecht so aus dem Trägerband herausgebrochen bzw. ausgestanzt werden kann, wie es vom Anwender beabsichtigt wird.

Im normalen Herstellungsprozess treten üblicherweise nach dem Stanz-Präge-Vorgang eventuelle Abweichungen in der Lage des zungenartigen Vorsprungs gegenüber der Ebene des Trägerbandes auf. Nach dem erfindungsgemäßen Verfahren wird vorteilhafterweise nach Ausstanzen des zungenartigen Vorsprungs dieser im Falle einer eventuellen Abweichung seiner Ebene gegenüber der Ebene des Trägerbandes wieder in die plane Ebene des Metallstreifens zurückgedrückt, so dass sich eine exakte Positionierung des Vorsprungs für die nachfolgenden Verfahrensschritte (Spritzvorgang) ergibt.

In einer ersten Ausführungsform des Verfahrens wird das Trägerband so vorgestanzt, dass zwischen dem Träger-Bereich für die Aufnahme des Chipmoduls und der jeweiligen Spitze des zungenartigen Vorsprungs ein Spalt entsteht. Zur besseren Verankerung der Kunststoffumspritzung wird die zum zungenartigen Vorsprung gerichtete Kante des Trägerbereichs so abgeprägt, dass im Bereich des Spalts ein zum zungenartigen Vorsprung gerichteter Absatz entsteht. Als besonders vorteilhaft erweist es sich, dass so auf einfache Weise ein Chip-Modul mit stabiler Kunststoffumspritzung erhalten werden kann, der nach der Umspritzung zunächst auf dem Trägerband verbleibt und dann als Bandmaterial zusammen mit einer Vielzahl von Chip-Modulen transportiert und weiterverarbeitet werden kann.

Vorteilhafte Ausgestaltungen dieser ersten Ausführungsform des Verfahrens sind in den Ansprüchen 2 bis 7 angegeben.

In einer zweiten Ausführungsform des erfindungsgemäßen Verfahrens wird das Trägerband als Metallstreifen so vorgestanzt, dass sich die Vorderkante des zungenartigen Vorsprungs und eine Schnittkante im jeweiligen Eingangsbereich des Trägerbereichs direkt (ohne Spalt dazwischen) gegenüberliegen. In den Trägerbereich wird wenigstens eine zusätzliche Öffnung für eine verbesserte Haftung der aufzubringenden Kunststoff-Umspritzung gestanzt; vorteilhafterweise wird die zusätzliche Öffnung zwischen der zur Aufnahme des elektrischen oder elektronischen Bauelements vorgesehenen Grundfläche des Trägerbereichs und der zum zungenartigen Vorsprung gerichteten Kante im Eingangsbereich eingestanzt. Auf diese Weise lässt sich eine hohe Stabilität des späteren Chipmoduls erzielen, so dass es auch als Bandmaterial an Kunden verkauft werden kann.

Vorteilhafte Ausgestaltungen dieser zweiten Ausführungsform des Verfahrens sind in den Ansprüchen 8 bis 10 angegeben.

Es folgt die Aufbringung eines elektrischen oder elektronischen Bauelements auf die Grundfläche des Trägerbereich sowie die Verbindung von Anschlussdrähten des Bauelements mit Kontaktabschnitten des Trägerbandes. Anschließend erfolgt die Kunststoffumspritzung des Bauelements im Trägerbereich sowie im Verbindungsbereich im Spritzgießverfahren, wobei die Einspritzung über einen der beiden zungenartigen Vorsprünge erfolgt.
Anschließend erfolgt die Entfernung des Kunststoff-Anspritzkanals durch Bewegen der Zungen bzw. zungenartigen Vorsprünge; dies bedeutet, dass vor dem jeweiligen Aufwickeln auf eine Spule der zungenartige Vorsprung, über den die Einspritzung des Kunststoffs erfolgt ist, relativ zum Trägerbereich so bewegt wird, dass der Kunststoffanguss eines für die vorherige Kunststoff-Umspritzung notwendigen Kunststoffangusses entfernt wird. Vorteilhafterweise wird der mit dem Kunststoffanguss versehene zungenartige Vorsprung durch Druck auf die dem Kunststoffanguss abgewandte Seite bewegt, wobei die Stege so abgestützt werden, dass ein Bruch in der Zone mit verringerter Profil-Querschnittsfläche bzw. entlang der Sollbruch-Linie vermieden wird. Es erfolgt eine Auftrennung von metallischen Verbindungen zwischen dem Trägerbereich und dem restlichen Trägerband, wobei jedoch die Verbindung mittels der Stege durch Abstützung erhalten bleibt. Dieser Schritt dient zur Vorbereitung des elektrischen Testes des Bauelementes auf dem Trägerband.

Gemäss der ersten Ausführungsform wird der Spalt durch die Umspritzung mit Kunststoff ausgefüllt, wobei durch den Absatz eine Verankerung der Kunststoffumspritzung mit dem Trägerbereich erfolgt, so dass der langgestreckte Metallstreifen als Trägerband auf eine Spule gewickelt werden kann.

Gemäß der zweiten Ausführungsform des Verfahrens wird durch die Ausfüllung der zusätzlichen Öffnung bzw. zweiter zusätzlicher Öffnungen im Eingangsbereich eine Verankerung der Kunststoffumspritzung mit dem Trägerbereich erzielt, so dass auch hierbei eine hohe Stabilität beim Wickeln des Metallstreifens als Trägerband auf eine Spule zur Übermittlung an Kunden bzw. Weiterverarbeiter erzielt wird.

Nach der Umspritzung und Entfernung der Kunststoffangussreste werden (bei der späteren Weiterverarbeitung wie z.B. Herstellung von Chipkarten) die als Verbindung dienenden Stege des so erstellten Chip-Moduls aufgetrennt, wobei dies in der Praxis erst beim Kunden erfolgt, d.h. dass die so erstellten Module durch Druck oder durch einen zusätzlichen Stanzvorgang von dem restlichen Metallstreifen abgetrennt werden.

Die Aufgabe wird vorrichtungsgemäß dadurch gelöst, dass der Träger-Bereich entlang der Transporteinrichtung gesehen von zwei sich diametral gegenüberliegenden zungenartig ausgestanzten Vorsprüngen des Trägerbandes umgeben ist, dessen zum Trägerbereich gerichtete Vorderkante jeweils durchgestanzt ist, während die seitlichen Kanten der Vorsprünge so gestanzt sind, dass jeweils seitlich der Vorderkanten im Metallstreifen Verbindungen als Stege zwischen dem zungenartigen Vorsprung und dem Träger-Bereich verbleiben, wobei die Stege jeweils eine Zone verringerter Profilquerschnittsfläche aufweisen. Diese Zone ist vorzugsweise als Sollbruchlinie ausgebildet.

Vorteilhafte Ausgestaltungen des als Trägerband dienenden Metallstreifens sind in den Ansprüchen 20 bis 25 angegeben.

Als vorteilhaft erweist es sich, dass mittels Vorgabe der jeweiligen Zone mit verringerter Profil-Querschnittsfläche in den Stegen eine exakte Positionierung der Trennstellen zwischen dem zu erstellenden Chipmodul und dem restlichen langgestreckten Metallstreifen als Trägerband möglich ist. Als weiterer Vorteil erweist es sich, dass aufgrund der Zonen verringerter Profilquerschnittsfläche (Sollbruchlinien) auf eine hohe mechanische Kraftanwendung, die auch zu Schäden am Chip-Modul führen kann, verzichtet wird.

Die Stege weisen jeweils im Bereich ihrer Zone mit verringerter Profil-Querschnittsfläche vorzugsweise eine eingeprägte Einkerbung auf, die bei späterer Weiterverarbeitung durch Druck oder einen zusätzlichen Stanzvorgang aufgetrennt wird.

Vorteilhafterweise ergibt sich so ein vereinfachtes Herstellverfahren, da die Kerbe mit einem Folgeschnitt-Prägewerkzeug im Stanzvorgang geprägt werden kann.

In einer ersten Ausführungsform weist der als Trägerband dienende Metallstreifen zwischen dem Eingang des Trägerbereichs und dem jeweils zungenartigen Vorsprung einen Spalt auf, der ausgestanzt ist. Zur besseren Verankerung der aufzubringenden Kunststoffumspritzung weist der Trägerbereich im Spalt einen zum zungenartigen Vorsprung gerichteten und durch Prägung entstandenen Absatz auf.

In einer zweiten Ausführungsform weist der Metallstreifen an Stelle des Spaltes nur einen Schnitt auf, wobei sich die Vorderkante des zungenartigen Vorsprungs und eine Schnittkante im jeweiligen Eingangsbereich des Trägerbereichs direkt gegenüberliegen; dabei ist wenigstens im Eingangsbereich des Trägerbereichs eine Öffnung zur Verankerung der aufzubringenden Kunststoff-Umspritzung vorgesehen, so dass sich vorteilhafterweise eine hohe Stabilität der Chipmodule ergibt.

Im folgenden ist der Gegenstand der Erfindung anhand der Figuren 1 bis 3 näher erläutert.

Figur 1 zeigt in einer Draufsicht ausschnittsweise einen langgestreckten Metallstreifen als Trägerband, dessen vorgestanzte Struktur Trägerbereiche für aufzubringende elektrische oder elektronische Bauelemente, Kontaktierungsbereiche zum Anschluss elektrischer Leitungen des Bauelements sowie Stütz- und Verbindungsstege aufweist, wobei die Verbindungsstege mit einer Zone verringerter Profil-Querschnittsfläche als Sollbruchlinie versehen sind. Die auf dem Metallstreifen erkennbaren Richtungspfeile geben die Einspritzrichtung für die spätere Kunststoffumspritzung wieder.

In Figur 2a ist schematisch eine Draufsicht auf den Systemträger gezeigt, wobei anhand von Längsschnitt CC in Figur 2b der Zusammenhang zwischen Kunststoffanguss auf dem zungenartigen Vorsprung und der Kunststoffumspritzung erkennbar ist.
Figur 2c zeigt die Entfernung des Kunststoffanguss durch Umbiegen des zungenartigen Vorsprungs;
Figur 2d zeigt im Längsschnitt AA den von einem Anspritzkanal freien zungenartigen Vorsprung sowie die Kunststoffumspritzung des elektrischen bzw. elektronischen Bauelements;
Figur 2e zeigt einen Längsschnitt entlang der Linie BB, wobei die Zone verringerter Profil-Querschnittsfläche bzw. die Sollbruchlinie mit ihrer Einkerbung im Profil erkennbar ist.
Figur 3a zeigt eine gegenüber Figur 2a modifizierte Anordnung mit Draufsicht auf den Trägerbereich, wobei zwischen dem jeweiligen zungenartigen Vorsprung und dem Eingangsbereich des Trägerbereichs kein Spalt, sondern lediglich eine Schnittlinie erkennbar ist. Zur Verankerung der Kunststoffumspritzung sind dabei Öffnungen jeweils im Eingangsbereich des Systemträgers vorgesehen.
Figur 3b zeigt im Längsschnitt CC ausschnittsweise die Kunststoffumspritzung mit Verankerungsöffnung sowie den Anspritzkanal;
Figur 3c zeigt die Entfernung des Anspritzkanals durch Umbiegen des zungenartigen Vorsprungs;
Figur 3d zeigt im Längsschnitt AA bruchstückhaft die Kunststoffumspritzung mit Verankerung sowie den zungenartigen Vorsprung ohne Kunststoffanguss;
Figur 3e zeigt entlang Längsschnitt BB den Verbindungssteg zwischen Trägerbereich und dem restlichen Metallstreifen, wobei die Zone verringerter Profil-Querschnittsfläche bzw. die Sollbruchlinie mit ihrer Einkerbung im Profil erkennbar ist.

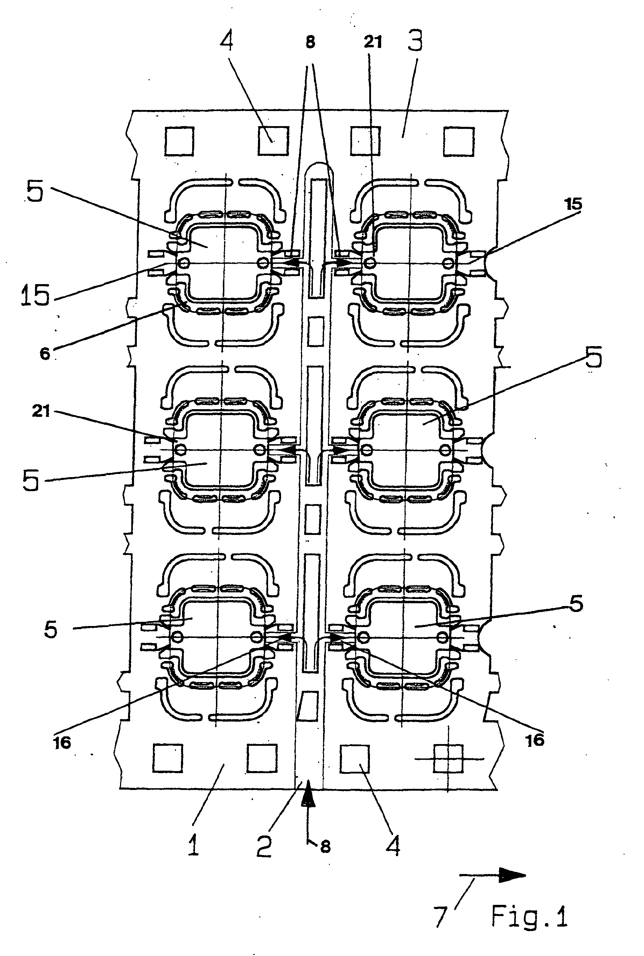

Gemäß Figur 1 weist der vorgestanzte langgestreckte Metallstreifen als Trägerband 1 an seinen beiden äußeren Rändern 2, 3 jeweils eine Perforation 4 auf, wobei das Format beispielsweise der Breite eines 35 mm Kinofilms entspricht, so dass im späteren Herstellungsverfahren Transportvorrichtungen aus der Filmtechnik einsetzbar sind. Es ist jedoch auch möglich beispielsweise einen doppelt so breiten Metallstreifen von beispielsweise 70 mm Breite einzusetzen.

Wie Figur 1 zu entnehmen ist, sind jeweils in Transportrichtung gemäß Pfeil 7 gesehen jeweils drei nebeneinanderliegende Trägerbereiche 5 erkennbar, die jeweils schrittweise transportiert werden. In den jeweiligen Trägerbereichen 5 werden die hier nicht gezeigten elektrischen bzw. elektronischen Bauelemente platziert, wobei von den Bauelementen ausgehende Leitungen mit seitlich des Trägerbereichs 5 befindlichen Kontaktfeldern 6 verbunden werden. Nach Bestückung des Trägerbandes 1 mit den jeweiligen Bauelementen (in Figur 1 nicht gezeigt) erfolgt über zungenartige Vorsprünge 16 die Kunststoffumspritzung, wobei die Einspritzrichtung gemäß Figur 1 durch Pfeil 8 dargestellt ist. Die weitere Verteilung der Kunststoff-Formmasse ist anhand der zu den (inneren) Eingangsbereichen 21 der jeweiligen Trägerbereiche 5 gerichteten Pfeile 8 erkennbar.

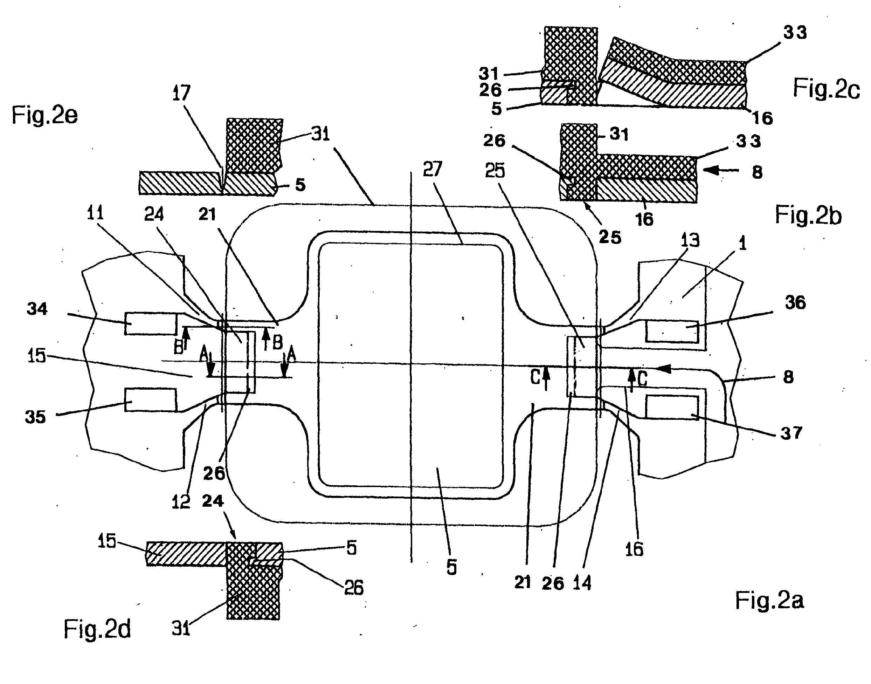

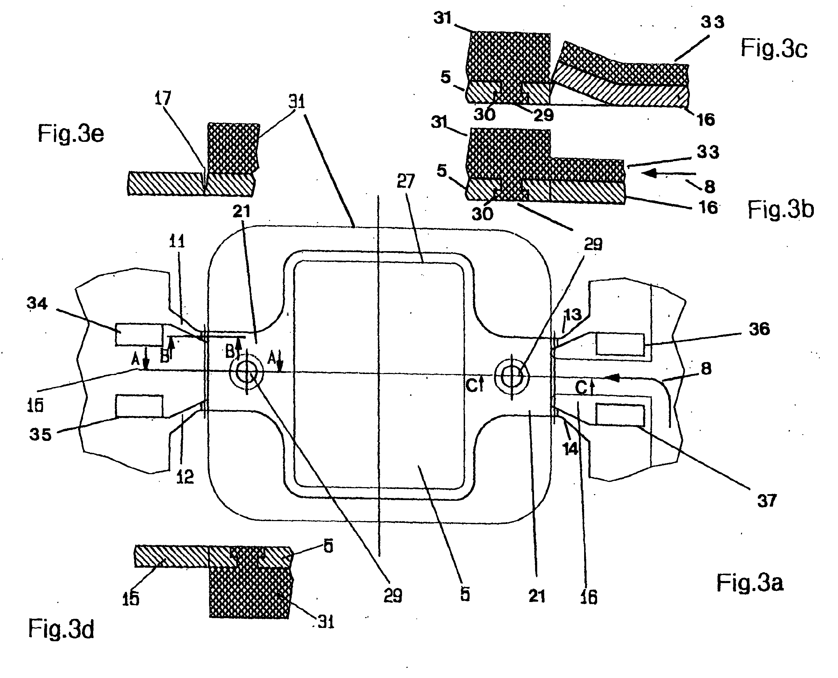

Die vom Umspritzvorgang abgedeckte Grundfläche ist nach Figur 2a, 3a mit einer durchgängigen Linie 27 dargestellt. Die dem jeweiligen Anspritzkanal bzw. den Kunststoffanguss 33 abgewandten zungenartigen Vorsprünge 15 und Eingangsbereiche 21 des Trägerbereichs 5 erhalten keinerlei Kunststoff, d.h. dass die Kunststoffumspritzung einseitig dem jeweiligen Modul zugeführt wird, wobei der jeweilige Anspritzkanal für den Kunststoffanguss 33 (Fig. 2b, 3b) dann im Abstand von zwei Trägerbereichen entlang der Transportrichtung 7 gesehen angeordnet ist. Der eigentliche Spritzvorgang erfolgt mit Hilfe eines hier nicht dargestellten Spritzgießwerkzeuges, wie es beispielsweise auch aus der EP 0 454 440 B1 bekannt ist. Die weiteren Schritte des Herstellungsverfahrens werden nachfolgend anhand der Figuren 2 und 3 näher erläutert.

Figur 2a zeigt in einer ausschnittsweisen Draufsicht das Trägerband 1 als Metallstreifen mit Trägerbereich 5, auf dem sich ein hier nicht dargestelltes Bauelement 23 befindet, dessen Grundfläche durch Linie 27 umrissen ist. Zwecks besserer Übersicht ist auf die Wiedergabe zusätzlicher Kontaktflächen verzichtet worden; es ist jedoch auch möglich, ein elektronisches Bauelement aufzubringen, welches als Transponder arbeitet und somit keinerlei Außenkontaktierung bzw. nur einen Antennenkontakt erfordert. Zwischen dem eigentlichen Trägerbereich 5 und dem übrigen Trägerband 1 ist jeweils ein zungenartiger Vorsprung 15, 16 vorgesehen, welcher jeweils durch einen Steg 11, 12, 13, 14 mit dem Eingangsbereich 21 des Systemträgers verbunden ist. Zwischen der jeweiligen Spitze des zungenartigen Vorsprungs 15 bzw. 16 und dem Eingangsbereich 21 befindet sich ein Spalt 24, 25, welcher während des Einspritzvorganges gefüllt wird. Der jeweilige Eingang 21 des Trägerbereiches weist auf seiner zum zungenartigen Vorsprung gerichteten Kante einen eingeprägten Absatz 26 auf, welcher zur Verankerung der aufzubringenden Kunststoffumspritzung dient. Gemäss Figur 2a und 2b erfolgt die Kunststoffumspritzung entlang der mit Pfeil 8 dargestellten Einspritzrichtung, wobei neben der eigentlichen Kunststoffumspritzung 31 des Bauelements auch ein Kunststoffanguss 33 entsteht, welcher vor einer Weiterverarbeitung zu entfernen ist. Die Entfernung erfolgt gemäss Figur 2c durch Anheben des zungenartigen Vorsprungs 16, wobei jedoch durch eine hier nicht dargestellte Abstützung die Bewegung so gering bleibt, dass keiner der Stege 13, 14 (bzw. 11, 12) an seiner Zone verringerter Profil-Querschnittsfläche bzw. Sollbruchstelle belastet wird. Anhand Figur 2b ist erkennbar, dass die Kunststoffumspritzung 31 und der Kunststoffanguss 33 noch zusammenhängend sind, während nach Figur 2c durch Anwinkeln bzw. Anhebens des zungenartigen Vorsprungs 16 bereits die Abtrennung des Kunststoffangusses 33 erfolgt ist. Weiterhin ist anhand der Figuren 2b, 2c auch der zum Vorsprung 16 gerichtete Absatz 26 erkennbar, welcher für eine sichere Verankerung der Kunststoffumspritzung 31 mit dem metallischen Trägerbereich 5 sorgt. Um eine möglichst einfache Trennung zwischen Vorsprung und Trägerbereich 5 später vornehmen zu können, ist der jeweilige zungenartige Vorsprung 15, 16 auf beiden Seiten jeweils von einer Ausnehmung 34, 35, 36, 37 umgeben.

Anhand Figur 2d ist die Kunststoffumspritzung 31 auf der der Anspritzrichtung 8 abgekehrten (äußeren) Seite zu erkennen, wobei entlang Schnitt AA ebenfalls Absatz 26 im Profil erkennbar ist, welcher für eine sichere Verankerung der Kunststoffumspritzung 31 sorgt. Der Vorsprung 15 weist hier keinen Anspritzkanal auf, da die Kunststoffumspritzung von der gegenüberliegenden Seite aus Richtung 8 erfolgt.

Anhand der Figur 2e ist im Schnitt BB die Einkerbung im Steg 11 erkennbar, welche hier als Zone 17 mit verringerter Profil-Querschnittsfläche bzw. als Sollbruchlinie dient. Die Einkerbung befindet sich direkt im Bereich der Kunststoffumspritzung, so dass nach deren Auftrennen entlang der vorherigen Sollbruchlinie eine saubere Trennstelle des kompletten Chipmoduls entsteht.

Gemäss Figur 3a grenzt die Spitze des zungenhaften Vorsprungs 15, 16 jeweils direkt an die Kante des Eingangsbereiches 21 von Trägerbereich 5, so dass hier zwar eine Trennung vorliegt jedoch kein Spalt (bzw. Spalt mit Breite Null) entsteht. Aufgrund der glatten Schnittkante des Eingangsbereichs 21 ist es jedoch nicht möglich, eine Halterungsmöglichkeit für die Kunststoffumspritzung 31 zu schaffen, so dass hier über separate Öffnungen 29 im Trägerbereich 5 eine Verankerungsmöglichkeit für die Kunststoffumspritzung 31 geschaffen werden muss. Auch hier wird die Einspritzrichtung durch Pfeil 8 symbolisiert, wobei ähnlich wie nach Figur 2a, 2b die Kunststoffumspritzung 31 sowie ein Kunststoffanguss 33 entstehen. Die Lösung des Kunststoffangusses 33 von der Kunststoffumspritzung 31 erfolgt hier ebenfalls wie anhand der Figuren 2a, 2b, 2c dargestellt durch Biegung des zungenhaften Vorsprungs 16, wobei hier ebenfalls der Vorsprung so abgestützt wird, dass die Verbindungsstege 13, 14 nicht aufgetrennt werden. Anhand der Figuren 3b und 3c ist auch klar erkennbar, dass es sich hier um eine durchgängige Schnittkante zwischen dem zungenartigen Vorsprung und dem Trägerbereich 5 handelt. Anhand Figur 3d ist erkennbar, dass der der Einspritzrichtung abgewandte Teil des zungenartigen Vorsprungs 15 keinen Anspritzkanal aufweist, so dass hier lediglich bei einer späteren Weiterarbeit jeweils der Steg 11, 12 mit seiner Einkerbung 17 gemäss Figur 3e aufzutrennen ist.

Die eigentliche Verankerung in der zusätzlichen Öffnung 29 weist einen Absatz 30 auf, so dass der zum Bodenbereich gerichtete Teil der Kunststoffumspritzung 31 durch eine nietkopfartige Verbreiterung die Kunststoffumspritzung fest arretiert ist. Die anhand Figur 3a beschriebene Ausführungsform entspricht im Wesentlichen den einzelnen Trägerbereichen der Figur 1.

## Patentansprüche

1. Verfahren zur Herstellung von Systemträgern aus einem metallischen Trägerband (1) als langgestreckter Metallstreifen für die Aufbringung von elektrischen oder elektronischen Bauelementen mit nachfolgender Kunststoffumspritzung als Chip-Modul, insbesondere als Modul für kontaktlose Chipkarten, wobei das Trägerband (1) entlang einer durch Randstreifen vorgegebenen Transportrichtung (7) in einzelne Segmente als Träger-Bereich (5) für Module aufgeteilt und zwecks späterer Trennung vorgestanzt wird, **dadurch gekennzeichnet, dass** der als Träger vorgesehene Bereich (5) so ausgestanzt wird, dass er entlang der Transportrichtung (7) gesehen von zwei sich diametral gegenüberliegenden zungenartigen Vorsprüngen (15, 16) des Trägerbandes (1) umgeben ist, wobei das Trägerband (1) jeweils zwischen zungenartigem Vorsprung (15, 16) und einem Eingang (21) des Trägerbereichs (5) wenigstens zum Teil so gestanzt wird, dass eine zum Trägerbereich gerichtete Spitze des zungenartigen Vorsprungs eine vordere Schnittkante sowie seitliche Schnittkanten erhält, die auf jeder Seite mit einer Verbindung als Steg (11, 12, 13, 14) im Trägerband (1) zwischen dem zungenartigen Teil des Vorsprungs (15, 16) und dem Trägerbereich (5) versehen sind, wobei die Stege (11, 12, 13, 14) jeweils eine Zone (17) mit verringerter Profil-Querschnittsfläche aufweisen, die nach Umspritzung des auf dem Träger-Bereich aufgebrachten Bauelements durch mechanische Einwirkung aufgetrennt wird.

2. Verfahren nach Anspruch 1, **dadurch gekennzeichnet, dass** die zungenartigen Vorsprünge (15, 16) beim Stanzen über jeweils zwei Stege (11, 12, 13, 14) mit dem Träger-Bereich (5) verbunden bleiben, wobei die Stege im Bereich ihrer jeweiligen Zone (17) mit verringerter Profil-Querschnittsfläche gegenüber dem Profil des übrigen Trägerbandes (1) reduzierter

3. Verfahren nach Anspruch 1 oder 2, **dadurch gekennzeichnet, dass** die Zone (17) mit verringerter Profil-Querschnittsfläche als Einkerbung im Steg (11, 12, 13, 14) ausgebildet wird.

4. Verfahren nach Anspruch 3, **dadurch gekennzeichnet, dass** die Zone (17) mit verringerter Profil-Querschnittsfläche als Einkerbung durch ein Folgeschnitt-Prägewerkzeug eingeprägt wird.

5. Verfahren nach einem der Ansprüche 1 bis 4, **dadurch gekennzeichnet, dass** nach Ausstanzen des zungenartigen Vorsprungs (15, 16) dieser im Falle einer eventuellen Abweichung seiner Ebene gegenüber der Ebene des Metallstreifens als Trägerband (1) wieder in die plane Ebene des Metallstreifens zurückgedrückt wird.

6. Verfahren nach einem der Ansprüche 1 bis 5, **dadurch gekennzeichnet, dass** der Metallstreifen (1) so vorgestanzt wird, dass zwischen dem Träger-Bereich (5) und der jeweiligen Spitze des zungenartigen Vorsprungs (15, 16) ein Spalt (24, 25) entsteht.

7. Verfahren nach Anspruch 6, **dadurch gekennzeichnet, dass** die zum zungenartigen Vorsprung (15,16) gerichtete Kante des Trägerbereichs (5) so abgeprägt wird, dass im Bereich des Spalts (24,25) ein zum zungenartigen Vorsprung (15,16) gerichteter Absatz (26) entsteht.

8. Verfahren nach einem der Ansprüche 1 bis 5, **dadurch gekennzeichnet, dass** der Metallstreifen so vorgestanzt wird, dass sich die Vorderkante des zungenartigen Vorsprungs (15, 16) und eine Schnittkante im jeweiligen Eingangsbereich (21) des Trägerbereichs (5) direkt (ohne Spalt dazwischen) gegenüberliegen.

9. Verfahren nach Anspruch 8, **dadurch gekennzeichnet, dass** in den Trägerbereich (5) wenigstens eine zusätzliche Öffnung für eine verbesserte Haftung der aufzubringenden Kunststoff-Umspritzung gestanzt wird.

10. Verfahren nach Anspruch 9, **dadurch gekennzeichnet, dass** die wenigstens eine zusätzliche Öffnung (29) zwischen der zur Aufnahme des elektrischen oder elektronischen Bauelements vorgesehenen Grundfläche des Trägerbereichs (5) und der zum zungenartigen Vorsprung gerichteten Kante im Eingangsbereich (21) eingestanzt wird.

11. Verfahren nach einem der Ansprüche 1 bis 10, **dadurch gekennzeichnet, dass** nach erfolgter Aufbringung eines elektrischen oder elektronischen Bauelements auf die Grundfläche (27) des Trägerbereich (5) und nach Auftrennung von metallischen Verbindungen zwischen dem Trägerbereich (5) und dem restlichen Metallstreifen als Trägerband (1) mit Ausnahme der Stege eine Kunststoff-Umspritzung durchgeführt wird, wobei die Einspritzung über einen der beiden zungenartigen Vorsprünge (15, 16) erfolgt.

12. Verfahren nach einem der Ansprüche 1 bis 7, **dadurch gekennzeichnet, dass** der Spalt (24, 25) durch die Umspritzung mit Kunststoff ausgefüllt wird, wobei durch den Absatz (26) eine Verankerung der Kunststoffumspritzung mit dem Trägerbereich (5) erfolgt.

13. Verfahren nach einem der Ansprüche 9 bis 11, **dadurch gekennzeichnet, dass** durch die Ausfüllung der zusätzlichen Öffnung (29) eine Verankerung der Kunststoffumspritzung mit dem Trägerbereich (5) erfolgt.

14. Verfahren nach einem der Ansprüche 11 bis 13, **dadurch gekennzeichnet, dass** der zungenartige Vorsprung (15, 16), über den die Einspritzung des Kunststoffs erfolgt ist, relativ zum Trägerbereich (5) so bewegt wird, dass der Kunststoff eines für die vorherige Kunststoff-Umspritzung notwendigen Kunststoffangusses (33) entfernt wird.

15. Verfahren nach Anspruch 14, **dadurch gekennzeichnet, dass** der mit dem Kunststoffangusses (33) versehene zungenartige Vorsprung (15, 16) durch Druck auf die dem Anspritzkanal abgewandte Seite bewegt wird, wobei die Stege (11, 12, 13, 14) so abgestützt werden, dass ein Bruch entlang der Zone (17) mit verringerter Profil-Querschnittsfläche vermieden wird.

16. Verfahren nach einem der Ansprüche 11 bis 15, **dadurch gekennzeichnet, dass** nach der Umspritzung und Entfernung der Kunststoffangüsse (33) die als Verbindung dienenden Stege (11, 12, 13, 14) des so erstellten Modules aufgetrennt werden.

17. Verfahren nach Anspruch 16, **dadurch gekennzeichnet, dass** die so erstellten Module durch Druck von dem restlichen Metallstreifen als Trägerband (1) abgetrennt werden.

18. Verfahren nach Anspruch 16, **dadurch gekennzeichnet, dass** die so erstellten Module durch zusätzliches Stanzen von dem restlichen Metallstreifen als Trägerband (1) abgetrennt werden.

19. Mit Perforation zur Führung entlang einer Transportrichtung (7) versehener Metallstreifen als Trägerband (1), der einen durch Stanzen gebildeten Träger-Bereich (5) für die Aufbringung eines elektrischen oder elektronischen Bauelements mit anschließender Kunststoff-Umspritzung aufweist, **dadurch gekennzeichnet, dass** der Träger-Bereich (5) entlang der Transporteinrichtung gesehen von zwei sich diametral gegenüberliegenden zungenartig ausgestanzten Vorsprüngen (15, 16) des Metallstreifens als Trägerband (1) umgeben ist, dessen zum Trägerbereich (5) gerichtete Vorderkante jeweils durchgestanzt ist, während die seitlichen Kanten der Vorsprünge (15, 16) so gestanzt sind, dass jeweils seitlich der Vorderkanten im Metallstreifen (1) Verbindungen als Stege (11, 12, 13, 14) zwischen dem zungenartigen Vorsprung (15, 16) und dem Träger-Bereich (5) verbleiben, wobei die Stege (11, 12, 13, 14) eine Zone (17) mit verringerter Profil-Querschnittsfläche aufweisen.

20. Metallstreifen nach Anspruch 19, **dadurch gekennzeichnet, dass** die Stege (11, 12, 13, 14) jeweils im Bereich ihrer Zone (17) mit verringerter Profil-Querschnittsfläche eine Sollbruchstelle aufweisen.

21. Metallstreifen nach Anspruch 19 oder 20, **dadurch gekennzeichnet, dass** die Zone (17) mit verringerter Profil-Querschnittsfläche als eingeprägte Einkerbung ausgebildet ist.

22. Metallstreifen nach einem der Ansprüche 19 bis 21, **dadurch gekennzeichnet, dass** zwischen dem Eingang des Trägerbereichs (5) und dem jeweils zungenartigen Vorsprung (15, 16) ein Spalt (24, 25) ausgestanzt ist.

23. Metallstreifen nach Anspruch 22, **dadurch gekennzeichnet, dass** der Trägerbereich (5) im Spalt (24, 25) einen zum zungenartigen Vorsprung (15, 16) gerichteten und durch Prägung entstandenen Absatz (26) aufweist.

24. Metallstreifen nach einem der Ansprüche 19 bis 23, **dadurch gekennzeichnet, dass** sich die Vorderkante des zungenartigen Vorsprungs (15, 16) und eine Schnittkante im jeweiligen Eingangsbereich (21) des Trägerbereichs (5) direkt gegenüberliegen.

25. Metallstreifen nach Anspruch 24, **dadurch gekennzeichnet, dass** sich im wenigstens einem Eingangsbereich (21) des Trägerbereichs (5) eine Öffnung (29) zur Verankerung der aufzubringenden Kunststoff-Umspritzung befindet.
